# EUROPÄISCHE PATENTSCHRIFT

(11) **EP 0 673 120 B1**
(45) Veröffentlichungstag und Bekanntmachung des Hinweises auf die Patenterteilung: **13.01.1999**
(21) Anmeldenummer: 95103176.4
(22) Anmeldetag: 06.03.1995
(51) Int. Cl.: H03L 7/085

(54) **Phasenregelschleife mit zusätzlichem Frequenzdiskriminator**
Phase locked loop comprising an additional frequency discrimination
Boucle à verrouillage de phase comportant un discriminateur de fréquence additionnel

(30) Priorität: 16.03.1994 DE 4409014
(43) Veröffentlichungstag der Anmeldung: 20.09.1995
(73) Patentinhaber: SIEMENS AKTIENGESELLSCHAFT, 80333 München (DE)
(72) Erfinder: Lehmann, Uwe, Dipl. Ing., D-85221 Dachau (DE); Sartorius, Volker, Dipl. Ing., D-82178 Puchheim (DE)

(56) Entgegenhaltungen:
- GB-A- 2 065 395
- US-A- 4 163 951
- IEEE TRANSACTIONS ON CONSUMER ELECTRONICS, Bd. CE-29, Nr. 3, August 1983 NEW YORK US, Seiten 179-194, NORIYUKI YAMASHITA ET AL. 'NEW SYSTEMS FOR VIDIEO PROCESSING ICs'
- Firmenschrift "Analog Dialogue" der Fa. Analog Device, 27-1 (1993), Seiten 3-6

## Beschreibung

Die Erfindung betrifft eine Phasenregelschleife mit zusätzlichem Frequenzdiskriminator entsprechend dem Oberbegriff des Anspruchs 1.

Phasenregelschleifen werden häufig zur Erzeugung von Taktsignalen insbesondere für die Regenerierung digitaler Signale benutzt. Die Phasenregelschleifen erhalten dazu einen Phasendiskriminator, der durch Vergleich eines aus einem Empfangssignal abgeleiteten Taktsignals und eines örtlich erzeugten Taktsignals ein Nachstimmsignal für einen in der Phasenregelschleife enthaltenen örtlichen Oszillator erzeugt. Um Phasenfehler bei Frequenzänderungen des Empfangssignals zu vermeiden, werden üblicherweise sogenannte Phasenregelschleifen zweiter Ordnung verwendet, die Integratoren enthalten. Probleme beim Einrasten derartiger Phasenregelschleifen können bei hoher Frequenzablage dadurch entstehen, daß die vom Phasendiskriminator abgegebene Restgleichspannung nach Verstärkung einen Spannungswechsel am Ausgang des dem steuereingang des örtlichen Oszillators vorgeschalteten schleifenverstärkers über den gesamten Abstimmbereich des örtlichen Oszillators verhindert. Zur Abhilfe kann in bekannter Weise eine Hilfsspannung zur Überkompensation des Phasendiskriminatoroffsets eingeschleift werden, es können auch vergleichsweise aufwendige Oszillatoren mit geringer Frequenzdrift bei großen Regelbandbreiten Verwendung finden. In beiden Fällen ergibt sich aber ein vergleichsweise hoher Aufwand, auch ist die universelle Verwendbarkeit in verschiedenen Frequenzbereichen nicht gegeben.

Eine Phasenregelschleife der eingangs erwähnten Art ist aus der Firmenschrift "Analog Dialogue" 27-1 (1993) Seiten 3 bis 6 der Firma "Analog Device" bekannt. In der Figur 4 dieser Veröffentlichung wird eine Phasenregelschleife beschrieben, die die Kombination eines Phasendiskriminators und eines Frequenzdiskriminators enthält. Die Ausgänge beider Diskriminatoren sind über einen Summierer mit dem Eingang eines Schleifenverstärkers verbunden, dessen Ausgangssignal über ein Schleifenfilter auf den Steuereingang des spannungsgesteuerten Oszillators der Phasenregelschleife geleitet wird. Nachteilig an dieser Schaltung ist, insbesondere im Hinblick auf eine universelle Anwendbarkeit, daß der Frequenzdiskriminator für unterschiedliche Frequenzbereiche speziell dimensioniert werden müßte.

Die Erfindung stellt sich die Aufgabe, eine Phasenregelschleife mit einem zusätzlichen Frequenzdiskriminator zu entwickeln, die bei vergleichsweise geringem Aufwand für unterschiedliche Frequenzbereiche der Eingangssignale bzw. der erzeugten Taktsignale geeignet sein soll.

Erfindungsgemäß wird die Aufgabe durch eine Phasenregelschleife der eingangs erwähnten Art gelöst, die entsprechend dem Kennzeichen des Patentanspruchs 1 weitergebildet ist. Von besonderem Vorteil bei der erfindungsgemäßen Lösung ist die leichte Integrierbarkeit durch den Wegfall induktiver Bauelemente, da die benötigten Filter mit RC-Gliedern aufgebaut werden können. Bevorzugte Ausbildungen der erfindungsgemäßen Phasenregelschleife sind in den Patentansprüchen 2 bis 5 näher beschrieben.

Die Erfindung soll im folgenden anhand eines in der Zeichnung dargestellten Ausführungsbeispiels näher erläutert werden. Dabei zeigt:
- Figur 1: das Blockschaltbild der für die Erfindung wesentlichen Teile einer erfindungsgemäßen Phasenregelschleife,
- Figur 2: die Detailschaltung des erfindungsgemäßen Frequenzdiskriminators und
- Figur 3: einige Spannungsverlaufe für einen Frequenzdiskriminator mit differenziertem Phasenablagesignal und anschließender Begrenzung.

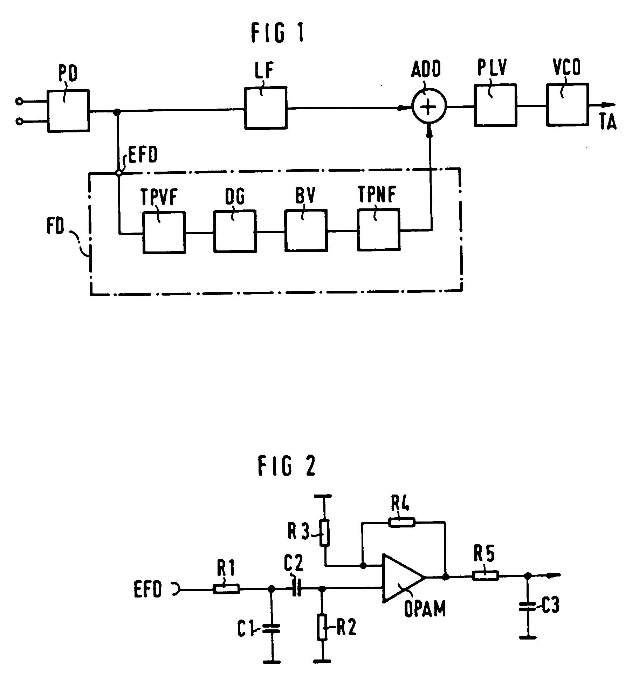

Das in der Figur 1 dargestellte Blockschaltbild einer erfindungsgemäßen Phasenregelschleife enthält in bekannter Weise einen getakteten Phasendiskriminator PD, dessen Ausgang mit dem Eingang eines Tiefpaßvorfilters LF verbunden ist. Abweichend vom Stand der Technik ist in die Verbindung zwischen dem Ausgang des Tiefpaßvorfilters LF und einem nachgeschaltetem Schleifenverstärker PLV ein Addierglied ADD über einen seiner beiden Eingänge zwischengeschaltet. Der Ausgang des Addierglieds ADD ist mit dem Eingang des Schleifenverstärkers PLV verbunden, der seinerseits ein Steuersignal an einen spannungsgesteuerten Oszillator VCO abgibt. Dieser Oszillator kann auf der Grundfrequenz oder auch auf einer Harmonischen der Grundfrequenz schwingen, in diesem Falle ist mit dem Ausgang des spannungsgesteuerten Oszillators VCO der Ausgang A für das erzeugte Taktsignal nicht direkt sondern über einen Frequenzteiler verbunden. Die Rückkopplung vom Ausgang des Frequenzteilers bzw. des spannungsgesteuerten Oszillators VCO zum Phasendiskriminator PD wurde der Einfachheit halber weggelassen. Entsprechend der Erfindung ist der Frequenzdiskriminator dem Phasendiskriminator nicht parallel- sondern nachgeschaltet. Dazu ist mit dem Ausgang des Phasendiskriminators PD der Eingang EFD einer Frequenzdiskriminator-Reihenschaltung FD verbunden, die im Signalweg nacheinander ein Tiefpaßvorfilter TPVF, ein Differenzierglied DG, einen Begrenzerverstärker BV und ein Tiefpaßnachfilter TPNF enthält und deren Ausgang mit einem zweiten Eingang des Addierglieds ADD verbunden ist. Die Frequenzdiskriminator-Reihenschaltung FD mit dem Addierglied ADD ist also ein Zusatz zu einer an sich konventionellen Phasenregelschleife, bei dem aber im Hinblick auf die erfindungsgemäße Ankopplung an den Phasendiskriminatorausgang auf einen Frequenzabgleich verzichtet werden kann.

Die in der Figur 2 dargestellte Detailschaltung der Frequenzdiskriminator-Reihenschaltung FD nach der Figur 1 enthält eingangsseitig als Tiefpaßvorfilter TPVF ein erstes RC-Glied aus einem ersten Widerstand R1 und einem ersten Kondensator C1. Der eine Anschluß des ersten Widerstandes R1 stellt den Eingangsanschluß EFD der Frequenzdiskriminator-Reihenschaltung FD dar und ist direkt mit dem Ausgang des getakteten Phasendiskriminators PD verbunden. Der zweite Anschluß des zweiten Widerstandes R1 ist über den ersten Kondensator C1 mit Bezugspotential sowie mit dem Differenzierglied DG verbunden, das aus einem zweiten Kondensator C2 und einem zweiten Widerstand R2 besteht. Der eine Anschluß des zweiten Kondensators C2 ist mit dem ersten Widerstand R1 verbunden, der andere Anschluß des zweiten Kondensators C2 ist über den zweiten Widerstand R2 mit Bezugspotential und außerdem mit dem invertierenden Eingang eines als symmetrischer Begrenzerverstärkers BV geschalteten Operationsverstärkers OPAM verbunden. Der Ausgang des Operationsverstärkers OPAM ist über einen vierten Widerstand R4 mit dem nichtinvertierenden Eingang des Operationsverstärkers OPAM sowie über einen dritten Widerstand R3 mit Bezugspotential verbunden. Die Widerstände R4 und R3 stellen also einen Spannungsteiler für die Ausgangsspannung des Operationsverstärkers OPAM dar. Mit dem Ausgang des Operationsverstärkers OPAM ist weiterhin der eine Anschluß eines fünften Widerstandes R5 verbunden, dessen anderer Anschluß über einen dritten Kondensator C3 mit Bezugspotential und außerdem, als Ausgangsanschluß der Frequenzdiskriminator-Reihenschaltung, mit einem zweiten Eingang des Addierglieds ADD verbunden ist. Der fünfte Widerstand R5 und der dritte Kondensator C3 bilden das in der Figur 1 gezeigte Tiefpaßnachfilter TPNF.

Beim Ausführungsbeispiel wurde bei einer Ausgangsspannung des Phasendiskriminators von 2 Vss mit den Widerständen R3 und R4 eine 30fache Verstärkung des Operationsverstärkers OPAM eingestellt, der Begrenzungseinsatz ergab sich zu 1 Vₛₛ.

Entsprechend der Erfindung wird die Information über die Frequenzablage aus der Phasenänderungsgeschwindigkeit durch Differentiation des Phasendiskriminatorausgangssignals gewonnen. Voraussetzung ist dabei, daß die Ausgangssignale des Phasendiskriminators bei positiver und negativer Frequenzablage jeweils unterschiedliche Polarität aufweisen. Dies ist aber bei den üblicherweise verwendeten Phasendiskriminatoren auf der Basis der Exklusiv-Oder-Verknüpfung der empfangenen mit den örtlich erzeugten Signalen automatisch der Fall.

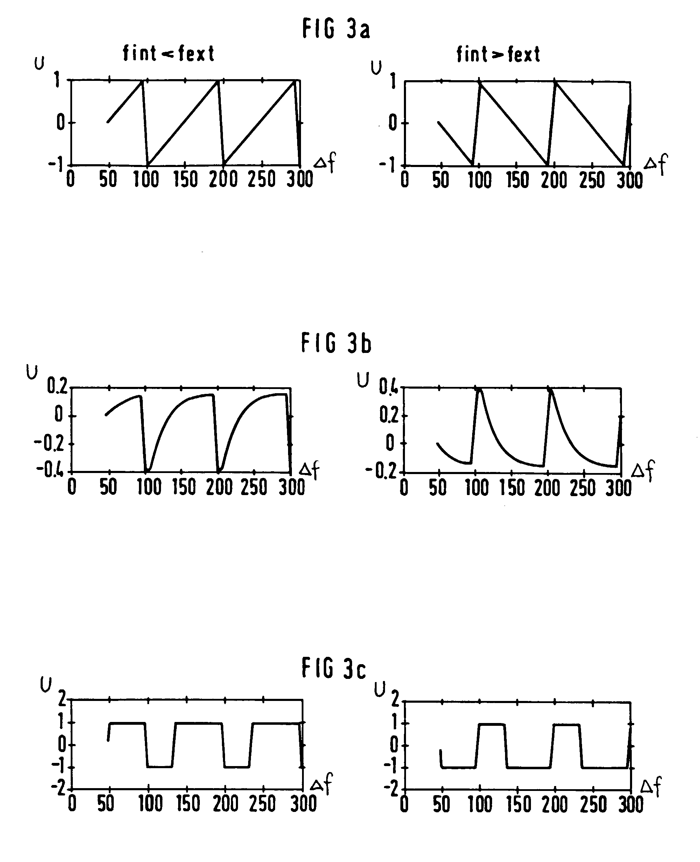

Zur Erläuterung der Wirkungsweise der erfindungsgemäßen Phasenregelschleife dient die Figur 3. In der Figur 3a ist das Ausgangssignal des Phasendiskriminators PD dargestellt, dabei gilt die linke Spalte für den Fall, daß die Frequenz (fint) des in der örtlichen Phasenregelschleife enthaltenen spannungsgesteuerten Oszillators VCO gegenüber der Taktfrequenz (fext) des Vergleichssignals zu niedrig ist, die rechte Spalte gilt für den Fall, daß die Schwingfrequenz zu hoch ist. Am Phasendiskriminatorausgang ergibt sich bei Veränderung der Frequenz ein sägezahnförmiger Verlauf der Amplitude U des Phasendiskriminatorausgangssignals der in Abhängigkeit von der normierten Frequenzdifferenz Δf dargestellt ist.

In der Figur 3b ist der Signalverlauf nach dem Differenzierglied DG, also am Eingang des Begrenzerverstärkers dargestellt, in der Figur 3c nach der Begrenzung. Es ist erkennbar, daß der Mittelwert des Ausgangssignals des Begrenzerverstärkers BG ein Maß für die Frequenzablage ist. Dabei kann in Abhängigkeit vom Einsatz des Begrenzers, von der Ablagefrequenz und von der Differentiationskonstante der erzeugte Gleichspannungswert und damit die Charakteristik der Frequenzdiskriminator-Reihenschaltung FD beeinflußt werden. Die Figur 3 zeigt, wie durch Filterung und symmetrische Begrenzung des Ausgangssignals des Phasendiskriminators PD eine Information über die Richtung der Ablagefrequenz im nichtgerasteten Zustand der Phasenregelschleife erhalten werden kann. Dabei konnte beim Ausführungssbeispiel die Schaltung bei einer Datenrate von 35 MBaud Frequenzablagen bis zu plus/minus 200 kHz erkennen.

## Patentansprüche

1. Phasenregelschleife mit einem Phasendiskriminator (PD), einem Schleifenfilter (LF) mit nachgeschaltetem Verstärker (PLV) und mit einem spannungsgesteuerten Oszillator (VCO),
**dadurch gekennzeichnet,**
daß ein Phasendiskriminator (PD) vorgesehen ist, dessen Ausgangssignal für positive und negative Frequenzablagen zwischen der Schwingfrequenz des Oszillators (VCO) und der Taktfrequenz der Eingangssignale der Phasenregelschleife jeweils unterschiedliche Polarität aufweist,
daß an die Verbindung zwischen einem Ausgang des Phasendiskriminators (PD) und dem Schleifenfilter (LF) eine Frequenzdiskriminator-Reihenschaltung (FD) aus einem Tiefpaßvorfilter (TPVF), einem Differenzierglied (DG), einem Begrenzerverstärker mit symmetrischer Begrenzung(BV) und einem Tiefpaßnachfilter (TPNF) angeschlossen ist,
daß das Schleifenfilter (LF) mit dem einen Eingang und der Ausgang der Frequenzdiskriminator-Reihenschaltung (FD) mit dem anderen Eingang eines Addierglieds (ADD) verbunden ist und daß an dessen Ausgang der Eingang des Schleifenverstärkers (PLV) angeschlossen ist.

2. Phasenregelschleife nach Patentanspruch 1,
**dadurch gekennzeichnet,**
daß die Frequenzdiskriminator-Reihenschaltung (FD) einen ersten bis vierten Widerstand (R1...R4), einen ersten und zweiten Kondensator (C1, C2) und einen Operationsverstärker (OPAM) enthält,
daß mit dem Eingang (EFD) der Frequenzdiskriminator-Reihenschaltung (FD) der eine Anschluß des ersten Widerstandes (R1) verbunden ist, daß dessen anderer Anschluß über den ersten Kondensator (C1) mit Bezugspotential und über den zweiten Kondensator (C2) mit dem einen Anschluß des zweiten Widerstandes (R2) und mit dem invertierenden Eingang des Operationsverstärkers (OPAM) verbunden ist,
daß der andere Anschluß des zweiten Widerstandes (R2) mit Bezugspotential verbunden ist und daß der nichtinvertierende Eingang des Operationsverstärkers (OPAM) über den dritten Widerstand (R3) mit Bezugspotential und über den vierten Widerstand (R4) mit dem Ausgang des Operationsverstärkers (OPAM) verbunden ist.

3. Phasenregelschleife nach Anspruch 2,
**dadurch gekennzeichnet,**
daß mit dem Ausgang des Operationsverstärkers (OPAM) der eine Anschluß eines fünften Widerstandes (R5) verbunden ist, dessen anderer Anschluß über einen dritten Kondensator (C3) mit Bezugspotential und außerdem direkt mit dem Ausgang der Frequenzdiskriminator-Reihenschaltung (FD) verbunden ist.

4. Phasenregelschleife nach Ansprüchen 1 oder 2,
**dadurch gekennzeichnet,**
daß die Grenzfrequenz des aus dem ersten Widerstand (R1) und dem ersten Kondensator (C1) gebildeten Tiefpaßvorfilters (TPVF) weit innerhalb der Bandbreite der Phasenregelschleife liegt.

5. Phasenregelschleife nach Anspruch 1,
**dadurch gekennzeichnet,**
daß ein getakteter Phasendiskriminator (PD) auf der Basis einer Exklusiv-Oder-Verknüpfung vorgesehen ist.

## Claims

1. Phase-locked loop having a phase discriminator (PD), a loop filter (LF) with an amplifier (PLV) connected downstream, and having a voltage-controlled oscillator (VCO),
characterized
in that a phase discriminator (PD) is provided whose output signal has a respectively different polarity for positive and negative frequency deviations between the oscillation frequency of the oscillator (VCO) and the clock frequency of the input signals of the phase-locked loop,
in that a frequency discriminator series circuit (FD) comprising a low-pass prefilter (TPVF), a differentiating element (DG), a limiter amplifier with balanced limiting (BV) and a low-pass postfilter (TPNF) is connected to the junction between an output of the phase discriminator (PD) and the loop filter (LF),
in that the loop filter (LV) is connected to one input and the output of the frequency discriminator series circuit (FD) is connected to the other input of an adder (ADD),
and in that the input of the loop amplifier (PLV) is connected to the output of the said adder.

2. Phase-locked loop according to Patent Claim 1,
characterized
in that the frequency discriminator series circuit (FD) contains a first to fourth resistor (R1...R4), a first and second capacitor (C1, C2) and an operational amplifier (OPAM),
in that one terminal of the first resistor (R1) is connected to the input (EFD) of the frequency discriminator series circuit (FD), in that the other terminal of the said first resistor is connected via the first capacitor (C1) to reference-earth potential and via the second capacitor (C2) to one terminal of the second resistor (R2) and to the inverting input of the operational amplifier (OPAM),
in that the other terminal of the second resistor (R2) is connected to reference-earth potential, and in that the non-inverting input of the operational amplifier (OPAM) is connected via the third resistor (R3) to reference-earth potential and via the fourth resistor (R4) to the output of the operational amplifier (OPAM).

3. Phase-locked loop according to Claim 2,
characterized
in that one terminal of a fifth resistor (R5) is connected to the output of the operational amplifier (OPAM), the other terminal of which fifth resistor is connected via a third capacitor (C3) to reference-earth potential and, in addition, directly to the output of the frequency discriminator series circuit (FD).

4. Phase-locked loop according to Claim 1 or 2,
characterized
in that the cut-off frequency of the low-pass prefilter (TPVF) formed from the first resistor (R1) and the first capacitor (C1) is well within the bandwidth of the phase-locked loop.

5. Phase-locked loop according to Claim 1,
characterized
in that a clocked phase discriminator (PD) based on an EXCLUSIVE-OR function is provided.

## Revendications

1. Boucle à verrouillage de phase comportant un discriminateur de phase (PD), un filtre de boucle (LF) ayant un amplificateur (PLV) branché du côté aval et un oscillateur commandé par tension (VCO),
caractérisée par le fait que
il est prévu un discriminateur de phase (PD) dont le signal de sortie a chaque fois une polarité différente pour une dérive de fréquence positive et pour une dérive de fréquence négative entre la fréquence d'oscillation de l'oscillateur (VCO) et la fréquence d'horloge des signaux d'entrée de la boucle à verrouillage de phase,
il est raccordé sur la liaison entre une sortie du discriminateur de phase (PD) et le filtre de boucle (LF) un circuit série discriminateur de fréquence (FD) constitué d'un filtre amont passe-bas (TPVF), d'un élément dérivateur (DG), d'un amplificateur limiteur (BV) avec limitation symétrique et d'un filtre aval passe-bas (TPNF),
le filtre de boucle (LF) est relié à l'une des entrées d'un élément additionneur (ADD) et la sortie du circuit série discriminateur de fréquence (FD) est reliée à l'autre entrée de l'élément additionneur (ADD) et
la sortie de l'élément additionneur est reliée à l'entrée de l'amplificateur de boucle (PLV).

2. Boucle à verrouillage de phase selon la revendication 1,
caractérisée par le fait que
le circuit (FD) série discriminateur de fréquence contient quatre (première à quatrième) résistances (R1 à R4), deux (premier et second) condensateurs (C1, C2) et un amplificateur opérationnel (OPAM),
l'entrée (EFD) du circuit (FD) série discriminateur de fréquence est reliée à l'une des bornes de la première résistance (R1) dont l'autre borne est reliée par l'intermédiaire du premier condensateur (C1) au potentiel de référence et par l'intermédiaire du deuxième condensateur (C2) à l'une des bornes de la deuxième résistance (R2) et à l'entrée inversée de l'amplificateur opérationnel (OPAM), et l'autre borne de la deuxième résistance (R2) est reliée au potentiel de référence et l'entrée non inversée de l'amplificateur opérationnel (OPAM) est reliée par l'intermédiaire de la troisième résistance (R3) au potentiel de référence et par l'intermédiaire de la quatrième résistance (R4) à la sortie de l'amplificateur opérationnel (OPAM).

3. Boucle à verrouillage de phase selon la revendication 2,
caractérisée par le fait que
la sortie de l'amplificateur opérationnel (OPAM) est reliée à l'une des bornes d'une cinquième résistance (R5) dont l'autre borne est reliée par l'intermédiaire d'un troisième condensateur (C3) au potentiel de référence et en outre directement à la sortie du circuit (FD) série discriminateur de fréquence.

4. Boucle à verrouillage de phase selon les revendications 1 ou 2,
caractérisée par le fait que
la fréquence limite du filtre amont passe-bas (TPVF) formé de la première résistance (R1) et du premier condensateur (C1) est bien à l'intérieur de la largeur de bande de la boucle à verrouillage de phase.

5. Boucle à verrouillage de phase selon la revendication 1,
caractérisée par le fait que
il est prévu un discriminateur de phase (PD) soumis à une horloge et basé sur une combinaison Ou-Exclusif.
